(19) Europäisches Patentamt
European Patent Office
Office européen des brevets

(11) EP 1 833 937 B1

(12) EUROPEAN PATENT SPECIFICATION

(45) Date of publication and mention of the grant of the patent:
**02.06.2010 Bulletin 2010/22**

(21) Application number: **05818832.7**

(22) Date of filing: **25.10.2005**

(51) Int Cl.:
***C09G 1/00*** *(2006.01)* ***C09G 1/02*** *(2006.01)*

(86) International application number:
**PCT/US2005/038372**

(87) International publication number:
**WO 2006/065347 (22.06.2006 Gazette 2006/25)**

(54) **POLISHING SOLUTIONS**

POLIERLÖSUNGEN

SOLUTIONS DE POLISSAGE

(84) Designated Contracting States:
**AT BE BG CH CY CZ DE DK EE ES FI FR GB GR HU IE IS IT LI LT LU LV MC NL PL PT RO SE SI SK TR**

(30) Priority: **10.12.2004 US 9608**

(43) Date of publication of application:
**19.09.2007 Bulletin 2007/38**

(73) Proprietor: **3M Innovative Properties Company**
**St. Paul MN 55133-3427 (US)**

(72) Inventor: **KOLLODGE, Jeffrey S.**
**Saint Paul, MN 55133-3427 (US)**

(74) Representative: **von Kreisler Selting Werner**
**Deichmannhaus am Dom**
**Bahnhofsvorplatz 1**
**50667 Köln (DE)**

(56) References cited:
**EP-A- 1 577 934**
**WO-A-01/23485**
**US-A1- 2001 018 407**
**US-A1- 2003 047 539**
**US-A1- 2005 139 803**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 833 937 B1

## Description

### FIELD

The invention provides polishing solutions for chemical mechanical planarization of, for example, semiconductor wafers. The polishing solutions comprise at least two organic acids. The invention also provides methods of polishing the surface of a substrate.

### BACKGROUND

During the manufacture of semiconductor devices, a wafer typically undergoes numerous processing steps including deposition, patterning, and etching. After one or more of these processing steps, it may be necessary to modify the surface of the wafer to, for example, achieve a high level of surface planarity and uniformity. Typical surface modifying processes include abrading, finishing, polishing, and planarizing.

A conventional surface modifying technique comprises polishing, for example, the chemical mechanical planization (CMP), of a semiconductor wafer, wherein a wafer in a carrier assembly is rotated in contact with a polishing pad in a CMP apparatus. The polishing pad is mounted on a turntable or platen. The wafer is mounted on a rotating/moving carrier or polishing head, and a controllable force presses the wafer against the rotating polishing pad. Thus, the CMP apparatus produces polishing or abrading movement between the surface of the wafer and the polishing pad. Typical CMP can be performed on a silicon wafer itself; on various dielectric layers, for example, silicon dioxide; on conductive layers, for example, aluminum and copper; or on layers containing both conductive and dielectric materials, as in Damascene processing.

Polishing solutions, also called working liquids, containing chemical agents can be dispensed onto the pad and wafer to aid in processing. Generally, there is a desire for additional polishing solution compositions.

### SUMMARY

The present invention relates to polishing solutions for use in chemical mechanical planarization and methods for their use.

Briefly, in one aspect, the present invention provides a polishing solution comprising two different organic acids. In some embodiments, the first organic acid is a multifunctional amino acid and the second acid is selected from the group consisting of a simple carboxylic acids, including monofunctional and multifunctional simple carboxylic acids, and monofunctional hydroxy-carboxylic acids; wherein the term "monofunctional" refers to an acid having a single carboxyl group, while the term "multifunctional" refers to an acid having a plurality of carboxyl groups.

In some embodiments, the polishing solution comprises a third organic acid. In some embodiments, the polishing solution comprises abrasive particles. In some embodiments, the polishing solution comprises a passivating agent.

In another aspect, the present invention provides a polishing solution comprising a first organic acid and a second organic acid wherein

(a) the first organic acid is a first multifunctional amino acid and the second organic acid is selected from the group consisting of

- (i) a second multifunctional amino acid;
- (ii) a monofunctional simple carboxylic acid;
- (iii) a multifunctional simple carboxylic acid;
- (iv) a monofunctional hydroxy-carboxylic acid;
- (vi) combinations thereof; or

(b) the first organic acid is a monofunctional hydroxy-carboxylic acid and the second organic acid is selected from the group consisting of

- (i) a monofunctional simple carboxylic acid;
- (ii) a multifunctional simple carboxylic acid; and
- (iii) combinations thereof;

wherein the removal rate obtained using the polishing solution is greater than the removal rate predicted by a linear estimate based on the removal rate obtained using a polishing solution containing the first organic acid alone and the removal rate obtained using a polishing solution containing the second organic acid alone. In some embodiments, the

removal rate obtained using the polishing solution is greater than both the removal rate obtained using a polishing solution containing the first organic acid alone and the removal rate obtained using a polishing solution containing the second organic acid alone.

In another aspect, the present invention provides a method of polishing a surface of a substrate comprising (a) introducing a polishing solution of the present invention to an interface between the surface of the substrate and a surface of a polishing article; and (b) providing a relative motion between the surface of the substrate and the surface of the polishing article. In some embodiments, the polishing article is a fixed abrasive article.

The above summary of the present invention is not intended to describe each embodiment of the present invention. The details of various embodiments of the invention are also set forth in the description below. Other features, objects, and advantages of the invention will be apparent from the description and from the claims.

## DETAILED DESCRIPTION

Methods of modifying a substrate surface using a polishing pad are well known. Generally, the wafer surface is brought into contact with the polishing pad and they are moved relative to each other in order to remove material from the wafer surface. In some conventional methods of modifying or refining exposed surfaces of structured wafers a polishing solution may be used. Generally, the polishing solution contains chemical agents that modify the removal rate. In some embodiments, the polishing solution contains a plurality of loose abrasive particles dispersed in a liquid. Exemplary abrasive articles include those described in U.S. Patent No. 6,238,592. The above-described process is commonly referred to as a chemical mechanical planarization (CMP) process.

Methods of modifying a substrate surface using a fixed abrasive article are also well known. One such method generally includes contacting a substrate and a fixed abrasive article with a desired pressure and relative motion, for example, rotational, linear, random, or otherwise, between them. Polishing solutions may be used to modify removal rates.

Generally, an abrasive article is an article capable of mechanically and/or chemically removing material from a surface of a substrate. An abrasive article can be a fixed abrasive article, that is, an abrasive article that comprises a plurality of abrasive particles in fixed positions in a binder. A fixed abrasive article is substantially free of unattached abrasive particles except as may be generated during the planarization process. Although these unattached abrasive particles may be present temporarily, they are generally removed from the interface between the fixed abrasive article and the substrate undergoing CMP and do not substantially contribute to the surface modification process. The abrasive article may be a three-dimensional fixed abrasive article having abrasive particles dispersed throughout at least a portion of its thickness such that erosion exposes additional abrasive particles. The abrasive article can also be textured such that it includes raised portions and recessed portions in which at least the raised portions include abrasive particles in a binder. Fixed abrasive articles are described, for example, in U.S. Patent Nos. 5,014,468; 5,453,312; 5,454,844; 5,692,950; 5,820,450; 5,958,794; and 6,612,916; and WO 98/49723.

In some embodiments, the abrasive article should provide a good removal rate. In some embodiments, the abrasive article is capable of yielding a processed substrate, for example, a semiconductor wafer, having an acceptable flatness and surface finish, and minimal dishing. In some embodiments, the fixed abrasive article is capable of yielding consistent levels of flatness, surface finish, or dishing over a series of consecutive surface modification processes. In some embodiments, it may be desirable to use the same fixed abrasive article to process different substrates.

A semiconductor wafer may comprise either a substantially pure surface or a surface processed with a coating or another material. Specifically, a semiconductor wafer may be in the form of a blank wafer with or without active microelectronic elements present (that is, a wafer prior to processing for the purpose of adding topographical features such as conductive and insulating areas), or a processed wafer (that is, a wafer after it has been subjected to one or more processing steps to add topographical features to the wafer surface). The term "processed wafer" also includes, but it is not limited to, "blanket" wafers in which the blank wafer has been processed to comprise a homogenous, planar layer of one material (for example, silicon dioxide) or layers of two or more materials (for example, silicon dioxide, tantalum, and copper). In some embodiments, the exposed surface of a semiconductor wafer includes one or more metal-containing areas, for example, copper-containing areas.

In conventional semiconductor device fabrication schemes, a silicon blank wafer is subject to a series of processing steps that deposit uniform layers comprising regions of two or more discrete materials that together form a single tier of what will become a multi-tier structure. The individual elements within a given tier may be formed in a variety of ways by any of the means commonly employed in the art. The materials used and the order in which they are applied to form a single tier is dependent on the requirements for the specific device. Typical materials employed to form a single layer within a tier include, but are not limited to, the following. The insulating layer, that is, the dielectric layer, is typically a metal oxide such as silicon dioxide, BPSG (borophosphosilicate glass), PSG (phosphosilicate glass), or combinations thereof. Other suitable dielectric layers may include low dielectric constant (K) layers such as carbon-doped oxides, porous carbon-doped oxide, porous spin-on dielectrics and polymeric films, and other materials having a dielectric constant generally in the range of 1.0 to 3.5, for example, between 1.5 and 3.5. An insulating cap and/or stop layer may

optionally be deposited within the tier. Examples of cap and/or stop layers include silicon carbide and silicon nitride. Optionally, adhesion/barner layers may also be included within the tier. Typical adhesion/barrier layers may comprise tantalum, tantalum nitride, titanium, titanium nitride, chromium, molybdenum, tungsten, or ruthenium, for example. Examples of materials used for the metal layer include aluminum, copper, and tungsten.

In some embodiments, the deposited metal layer is modified, refined or finished by removing portions of the deposited metal and optionally portions of the adhesion/barrier layer from the surface of the dielectric. Typically, enough surface metal is removed so that the outer exposed modified surface of the wafer comprises metal, and either a barrier layer, a cap layer, an oxide dielectric material, or a combination thereof. A top view of the exposed wafer surface would reveal a planar surface with metal corresponding to the etched pattern and dielectric material adjacent to the metal.

Generally, surface modification may be enhanced when it is conducted in the presence of a polishing solution in contact with the substrate and the polishing pad or fixed abrasive article according to the present invention. In some embodiments, the polishing solution comprises water, for example, tap water, distilled water, or deionized water. In some embodiments, the polishing solution is chosen based on the properties (for example, composition, surface texture, etc.) of the substrate to provide the desired surface modification without adversely affecting or damaging the substrate.

In some embodiments, the polishing solution comprises abrasive particles. Any known abrasive particles may be used including, for example, silica, alumina, and ceria.

In some embodiments, the polishing solution in combination with the polishing pad, abrasive particles in the polishing solution, and/or a fixed abrasive article, may contribute to processing through a chemical mechanical polishing process. During the chemical portion of polishing, the polishing solution may react with the outer or exposed wafer surface. During the mechanical portion of processing, the abrasive article may then remove this reaction product. In some embodiments, the removal rate will be increased when polishing occurs in the presence of particular polishing solutions relative to the removal rate achieved in the absence of such polishing solutions.

The present invention provides polishing solutions comprising two different types of organic acid. Generally, the acids may be added as free acids or as the salts thereof. In some embodiments, these polishing solutions can enhance polishing performance, for example, removal rates.

One class of organic acids is carboxylic acids, which may be subdivided into (1) simple carboxylic acids, (2) hydroxy-carboxylic acids, and (3) amino acids.

Carboxylic acids contain the carboxyl group

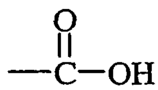

attached to hydrogen (HCOOH), an alkyl group (RCOOH), or an aryl group (ArCOOH). Carboxylic acids may have one carboxyl group (that is, monofunctional carboxylic acids) or a plurality of carboxylic acid groups (that is, multifunctional carboxylic acids), for example, difunctional carboxylic acids (that is, dicarboxylic acids) and trifunctional carboxylic acids (that is, tricarboxylic acids). As used herein, the terms "monofunctional", "difunctional", "trifunctional," and "multifunctional" refer to the number of carboxyl groups on the acid molecule.

Simple carboxylic acids consist of carbon, hydrogen, and one or more carboxyl groups. Exemplary monofunctional simple carboxylic acids include, for example, formic, acetic, propionic, butyric, isobutyric acid, 3-butenoic acid, capric, lauric, stearic, oleic, linoleic, linolenic, phenylacetic, benzoic, and toluic acids. Exemplary multifunctional simple carboxylic acids include, for example, oxalic, malonic, methylmalonic, succinic, glutaric, adipic, maleic, fumaric, phthalic, isophthalic, and terephthalic acids.

Substituted carboxylic acids contain one or more substituents, for example, halides, hydroxyl groups, amino groups, ether groups, and/or carbonyl groups in addition to the one or more carboxyl groups. Hydroxy-carboxylic acids, which comprise one or more hydroxyl groups, are one class of substituted carboxylic acid. Exemplary hydroxy-carboxylic acids include monofunctional hydroxy-carboxylic acids and multifunctional hydroxy-carboxylic acids. Exemplary monofunctional hydroxy-carboxylic acids include glyceric acid (that is, 2,3-dihydroxypropanoic acid), glycolic acid, lactic acid (for example, L-lactic, D-lactic, and DL-lactic acids), hydroxy-butanoic acid, 3-hydroxypropionic acid, and methyllactic acid (that is, 2-hydroxyisobutyric acid). Exemplary multifunctional hydroxy-carboxylic acids include malic acid and tartaric acid (difunctional hydroxy-carboxylic acids) and citric acid (a trifunctional hydroxy-carboxylic acid).

Amino acids, which comprise a monofunctional or multifunctional carboxylic acid with one or more amino substituents, are another class of substituted carboxylic acid. Exemplary monofunctional amino acids include, for example, alanine, arganine, cysteine, glycine, lysine, pipecolinic acid, and proline (for example, L-proline). Exemplary multifunctional amino acids include, for example, aspartic acid, cystine, glutamic acid, ethylenediaminetetraacetic acid (EDTA), and iminodiacetic acids. As used herein, the term "iminodiacetic acids" includes unsubstituted iminodiacetic acid (that is, iminodiacetic acid) and substituted iminodiacetic acids such as, for example, methyliminodiacetic acid.

Some amino acids also have hydroxyl substituents such as, for example, serine and tyrosine.

In some embodiments, the polishing solution contains a passivating agent. Exemplary passivating agents include azole derivative such as for example, benzotriazole, tolyltriazole, and combinations thereof. In some embodiments, the concentration of the passivating agents in the polishing solution is at least about 0.025 wt%, and in some embodiments, at least about 0.05 wt%. In some embodiments, the concentration of the passivating agents in the polishing solution is no greater than about 0.30 wt%, in some embodiments, no greater than about 0.15 wt%, or even no greater than about 0.10 wt%. Cuprous oxide is also known as a passivating agent. Other passivating agents are listed in Leidheiser, The Corrosion of Copper, Tin, and Their Alloys, (1971), pp.119-123.

The pH of the polishing solution may affect the solubility of the acids, as well as removal rate, selectivity, and other polishing parameters. Generally, pH is selected based upon the required solubility of the acids and the nature of the wafer surface being planarized including the chemical composition and topography of the wafer surface. In some embodiments, acidic solutions are preferred. In some embodiments, the pH is at least about 1, in some embodiments at least about 2, or even at least about 3. In some embodiments, the pH is no greater than about 6, in some embodiments, no greater than about 5, or even no greater than about 4. In some embodiments, neutral solutions are preferred, that is, solutions having a pH between about 6 and 8. In some embodiments, basic solutions are preferred, that is, solutions having a pH greater than about 8, or even greater than about 10.

The pH of the polishing solution may be adjusted by the addition of well-known compounds. For example, the pH may be adjusted by the addition of mineral acids (for example, phosphoric acid or sulfuric acid), hydroxides of alkali metals (for example, sodium hydroxide), hydroxides of alkaline earth metals (for example, calcium hydroxide), ammonium hydroxide, ammonium hydrogen phosphate, and ammonium dihydrogen phosphate. In some embodiments, buffers may be added to the polishing solution to control the pH and thus mitigate pH changes during wafer processing.

Generally, the polishing solution may contain additional components. For example, in some embodiments, the polishing solution contains one or more complexing agents. In some embodiments, the polishing solution contains oxidizing and/or bleaching agents such as, for example, hydrogen peroxide, nitric acid, and transition metal complexes such as ferric nitrate. In some embodiments, complexing agents may be combined with oxidizing agents. In some embodiments, the polishing solution may contain additives such as surfactants, wetting agents, rust inhibitors, lubricants, biocides, soaps, viscosity modifiers, and the like. These additives are chosen to provide the desired benefit without damaging the underlying semiconductor wafer surface. A lubricant, for example, may be included in the working fluid for the purpose of reducing friction between the abrasive article and the semiconductor wafer surface during planarization.

In some embodiments, all of the components are combined to form a single polishing solution which is then applied to the substrate and/or polishing pad. In some embodiments, one or more components may be added separately during substrate processing, and the complete polishing solution is formed in situ.

## EXAMPLES

The following specific, but non-limiting, examples will serve to illustrate the invention.

### Materials

Annealed, copper-coated blanket wafers, 200 mm in diameter, were obtained from Ramco Technolgy, Inc. (Los Altos, California). The wafers were single crystal silicon coated with the following layers in order from the surface of the silicon: about 500 nm (5,000Å) tetraethylorthosilicate (TEOS), about 25 nm (250Å) tantalum, about 100 nm (1,000Å) copper seed layer, and about 1500 nm (15,000Å) electroplated copper.

Cu CMP disc M6100 (MWR66) having a 51 cm (20 inch) outside diameter (O.D.) (product number 60-0700-0523-0) available from the 3M Company (St. Paul, Minnesota) was used as the fixed abrasive. Prior to use, the fixed abrasive was laminated onto a subpad. The subpad comprised a 0.51 mm (20 mil) thick sheet of polycarbonate laminated on top of a 2.3 mm (90 mil) thick foam sheet having a density of 0.19 grams per cubic centimeter (12 pounds per cubic foot) (available as Volara from Voltek (Lawrence, Massachusetts)). The fixed abrasive article was laminated to the polycarbonate layer of the subpad using a pressure sensitive adhesive.

Cu CMP Solution CPS-11, used for pad break-in, was obtained from the 3M Company. A hydrogen peroxide solution (30% by weight) was added to the CPS-11 prior to polishing. The CPS-11/30% $H_2O_2$ weight ratio was 945/55.

All polishing was conducted using a MIRRA 3400 Chemical-Mechanical Polishing System (Applied Materials, Inc., Santa Clara, California) with a TITAN carrier fitted with a solid retaining ring. A polishing pad was laminated to the platen of the MIRRA polishing tool via a layer of pressure sensitive adhesive. The pad was high pressure rinsed with deionized water for ten seconds. The pad was then conditioned by polishing a 200 mm (8 inch) diameter copper disc for six minutes at a platen speed of 101 rpm and a carrier speed of 99 rpm. Polishing solution, CPS-11 with hydrogen peroxide, was delivered at a flow rate of 120 mL/min. The polishing solution delivery arm was positioned to be as close to the pad center as possible. The polishing solution was delivered approximately 13-25 mm (0.5-1 inch) from the pad

center. During this pad conditioning, the pressures applied to the TITAN carrier inner tube, retaining ring, and membrane were 31 kPa, 34.5 kPa, and 31 kPa (4.5 psi, 5.0 psi, and 4.5 psi), respectively. The TITAN carrier sweep was a six zone, sinusoidal sweep ranging from 10-15 cm (4.2-5.6 inches) with a sweep frequency of six sweeps/min. After initial conditioning, no further pad conditioning was required. Following conditioning, the pad was high pressure rinsed with deionized water for fifteen seconds.

The platen and carrier speeds were set to 41 rpm and 39 rpm, respectively. The pressures applied to the TITAN carrier inner tube, retaining ring, and membrane were 31 kPa, 17.2 kPa, and 13.8 kPa (4.5 psi, 2.5 psi and 2.0 psi), respectively. The TITAN carrier sweep was set as described for pad conditioning. The polishing solution flow rate was 180 ml/min. The solution delivery arm was positioned as described for pad conditioning. Prior to polishing, for a given polishing solution composition, the solution delivery line was purged by flowing the desired polishing solution through the line at about 220 mL/min for about 90 seconds. A solid copper disc was then polished for 40 seconds with the polishing solution followed by the polishing of a copper blanket wafer for 40 seconds with the same polishing solution.

Removal rate was calculated by determining the change in thickness of the layer being polished. This change in thickness was divided by the wafer polishing time to obtain the removal rate for the layer being polished. For 200 mm diameter wafers, thickness measurements are taken with a ResMap 168-4. point probe Rs Mapping Tool (Credence Design Engineering, Inc., Cupertino, California). Eighty-one point diameter scans with 5 mm edge exclusion were employed.

For polishing solutions having a mixture of organic acids, actual removal rates were compared to estimated removal rates. A linear estimate of removal rate based on the mole fraction of acid groups in the polishing solution, as shown in Equation 1, was used.

$$\text{Linear Estimate of Removal Rate} = \sum R_i * x_i \qquad (1)$$

where,

$$1 = \sum x_{i,} \qquad (2)$$

and where $x_i$ is the mole fraction of acid groups in the fluid from organic acid i, and $R_i$ is the removal rate of a polishing solution containing only organic acid i. The mole fraction of acid groups in the polishing solution is

$$x_i = (M_i * N_i)/(\sum M_i * N_i), \qquad (3)$$

where $M_i$ is the number of moles of organic acid i in the polishing solution, and $N_i$ is the number of acid groups per molecule of organic acid i. In order to calculate the linear estimate, the total molar concentration of organic acid groups in the polishing solutions containing a single acid must be essentially the same as that of the polishing solution containing a mixture of the corresponding organic acids. That is, all polishing solutions must have essentially the same molar concentration of organic acid groups.

Polishing solutions were prepared using the materials described in Table 1. Each polishing solution contained deionized water, APDB, BTA, 30HP, and various mixtures of acids. The BTA was added to the polishing solutions as a solution of 0.4% BTA in deionized water. The BTA solution was preparation as follows: 16.00 g BTA were added to 4,000 g deionized water (DI water) contained in a beaker. A large TEFLON-coated magnetic stir bar was placed in the beaker. Rapid stirring of the solution was conducted until all of the BTA was dissolved. The resulting 0.4% BTA solution is designated as BTAS in the Examples.

To prepare the polishing solutions, APDB and the BTA solution were added to the DI water. Then, the appropriate acid(s) were added to the solution. Magnetic stirring was used to facilitate dissolution of the solid components. After all the components were dissolved, a pH measurement of the solution was taken.

Table 1: Material Descriptions

| Designation | Material | Available from |
|---|---|---|
| 30HP | Hydrogen peroxide, 30% by weight in water, CMOS™, stabilized CAS#7722-84-1 | J.T. Baker, a division of Mallinckrodt Baker, Inc. Phillipsburg, New Jersey |
| AcA | Acetic Acid, 99.7% CAS#64-19-7 | Sigma-Aldrich, Inc., St. Louis, Missouri |
| APDB | Ammonium Phosphate Dibasic, 98% CAS# 7783-28-0 | Sigma-Aldrich Inc. |
| BTA | Benzotriazole, 99% CAS# 95-14-7 | Aldrich Chemical Co., Inc. Milwaukee, Wisconsin |
| CA | Citric acid, 99.5% CAS#77-92-9 | Sigma-Aldrich, Inc. |
| DL-LA | DL-lactic acid bulk food/pharmaceutical grade CAS# 50-21-5 | J.T. Baker, a division of Mallinckrodt Baker, Inc. |
| EDTA | Ethylenediaminetetraacetic acid, A.C.S. reagent grade CAS#60-00-4 | Matheson Coleman & Bell, Norwood, Connecticut |
| GA | Glutaric Acid, 99% CAS#110-94-1 | Aldrich Chemical Co., Inc. |
| HIBA | 2-hydroxyisobutyric acid, 98% CAS# 594-61-6 | Sigma-Aldrich, Inc. |
| IDA-H | Iminodiacatic acid, 98% CAS# 142-73-4 | Hampshire Chemical, Midland, Michigan |
| IDA-P | Iminodiacatic acid, 98% CAS# 142-73-4 | Pfaltz & Bauer, Inc. Waterbury, Connecticut. |
| L-AA | L-aspartic acid, 98% CAS# 56-84-8 | Sigma-Aldrich, Inc. |
| L-AL | L-alanine, 99% CAS#56-41-7 | Sigma-Aldrich, Inc. |
| L-LA | L-lactic acid, 85% solution in water CAS# 79-33-4 | Sigma-Aldrich, Inc. |
| L-MA | L-malic acid 97% CAS#97-67-6 | Sigma-Aldrich, Inc. |
| PrA | Propionic Acid, 99% CAS# 79-09-4 | Sigma-Aldrich, Inc. |
| SA | Succinic acid, 99% CAS# 110-15-6 | Aldrich Chemical Co., Inc. |

The pH of the polishing solutions was measured using an Orion model 230A pH meter fit with an Orion low maintenance pH triode (9107BN) available from Orion Research Inc., Laboratory Products Group, Boston, Massachusetts. A standard two-point calibration was performed using buffer solutions of pH equal to 3.00 and 4.00 (available from VWR International, West Chester, Pennsylvania). When measuring the pH of the polishing solution or of a calibration standard, the pH probe was allowed to equilibrate five minutes in solution prior to recording a pH value.

Solution pH is known to influence copper removal rates in copper CMP applications; therefore, the pH of the polishing solutions was controlled to 3.37 $\pm$ 0.03, unless otherwise stated. Depending on the added acids, the pH of the polishing solution was often either slightly higher or slightly lower than the target value. If the pH was lower than the target, a small amount of ammonia solution (29 wt% in water, A.C.S. reagent grade (CAS# 1336-21-6), available from EMD chemicals, Hawthorne, New York) was added to bring the polishing solution pH into the target range. If the pH was higher than the target, a small amount of phosphoric acid solution (85 wt% in water, A.C.S. reagent grade (CAS# 7664-38-2), available from Aldrich Chemical Company, Inc., Milwaukee, Wisconsin) was added to bring the pH of the polishing solution into the target range. After pH adjustment, 30HP was added to the solution and magnetic stirring was continued for about two minutes.

Examples 1 - 5 and Comparative Examples CE-1 - CE-2

The polishing solutions of Examples 1-5 and Comparative Examples CE-1 - CE-2 were prepared according to the compositions of Table 2a. The two acids used were iminodiacetic acid (IDA-H), a multifunctional amino acid having two acid groups, and DL-lactic acid (DL-LA), a monofunctional hydroxy-carboxylic acid. Each solution was used to polish a copper blanket wafer. The total number of organic acid groups in the polishing solution was held essentially constant for all the examples. Removal rates are shown in Table 2b as a function of the mole fraction of organic acid groups in the solution from DL-LA.

A linear estimate of the removal rates for Examples 1 - 5 was made based on the removal rates of Comparative Examples CE-1 and CE-2. For example, for Example 1, the polishing solution comprised 0.80 mole fraction acid groups

from DL-LA. Thus, as calculated from Equation 2, the polishing solution comprised 0.20 (that is, 1-0.80) mole fraction acid groups from IDA-H. Applying Equation 1, the linear estimate for removal rate would be (0.80 * 8,291) + (0.20 * 6,581); which is 7,949. The percent increase relative to the linear estimate is shown in Table 2b. In addition to being greater than the rate predicted by the linear estimate, each combination of acids gave a higher removal rate than either acid alone.

Table 2a: Composition of polishing solutions (amounts in grams).

| Example | CE-1 | 1 | 2 | 3 | 4 | 5 | CE-2 |
|---|---|---|---|---|---|---|---|
| DI Water | 575.1 | 579.6 | 583.6 | 587.2 | 590.7 | 593.8 | 595.4 |
| APDB | 40.2 | 40.2 | 40.2 | 40.2 | 40.2 | 40.2 | 40.2 |
| BTAS | 251 | 251 | 251 | 251 | 251 | 251 | 251 |
| IDA-H | - | 11.5 | 23.0 | 33.0 | 43.2 | 51.8 | 57.6 |
| DL-LA | 77.9 | 62.3 | 46.8 | 33.2 | 19.5 | 7.8 | - |
| 30HP | 110 | 110 | 110 | 110 | 110 | 110 | 110 |

TABLE 2b: Removal rates.

| Example | Mole Fraction of Acid Groups from DL-LA | Removal Rate (Å/min) | Linear Estimate (Å/min) | % Increase |
|---|---|---|---|---|
| CE-1 | 1.00 | 8,291 | - | - |
| 1 | 0.80 | 9,186 | 7,949 | 16 |
| 2 | 0.60 | 10,368 | 7,607 | 36 |
| 3 | 0.43 | 10,514 | 7,311 | 44 |
| 4 | 0.25 | 10,581 | 7,008 | 51 |
| 5 | 0.10 | 8,933 | 6,752 | 32 |
| CE-2 | 0.00 | 6,581 | - | - |

Examples 6 - 9 and Comparative Example CE-3

The polishing solutions of Examples 6-9 and Comparative Example CE-3 were prepared according to the compositions of Table 3a. The two acids used were IDA-H, a multifunctional amino acid having two acid groups, and L-lactic acid (L-LA), a monofunctional hydroxy-carboxylic acid. Each solution was used to polish a copper blanket wafer. The total number of organic acid groups in the polishing solution was held essentially constant for all the examples. Removal rate results are shown in Table 3b as a function of the mole fraction of organic acid groups in the solution from L-LA. Comparative Example CE-3 was prepared twice. Polishing results for this example represent the average value of the two trials. A linear estimate of the removal rates for Examples 6-9 was made based on the removal rates of Comparative Examples CE-2 and CE-3. The percent increase of the measured removal rate relative to the linear estimate is shown in the last column of Table 3b. In all cases, the combination of acids gave a higher removal rate than either acid alone.

Table 3a: Composition of polishing solutions (amounts in grams).

| Example | CE-3 | 6 | 7 | 8 | 9 |
|---|---|---|---|---|---|
| DI Water | 561.4 | 575.3 | 581.4 | 587.3 | 592.4 |
| APDB | 40.2 | 40.2 | 40.2 | 40.2 | 40.2 |
| BTAS | 251 | 251 | 251 | 251 | 251 |
| IDA-H | - | 23.0 | 33.0 | 43.2 | 51.8 |
| L-LA | 91.6 | 55.0 | 39.1 | 22.9 | 9.2 |

(continued)

| Example | CE-3 | 6 | 7 | 8 | 9 |
|---|---|---|---|---|---|
| 30HP | 110 | 110 | 110 | 110 | 110 |

Table 3b: Removal rates.

| Example | Mole Fraction of Acid Groups from L-LA | Removal Rate (Å/min) | Linear Estimate (Å/min) | % Increase |
|---|---|---|---|---|
| CE-3 | 1.00 | 8,874 | - | - |
| 6 | 0.60 | 10,712 | 7,957 | 35 |
| 7 | 0.43 | 11,101 | 7,567 | 47 |
| 8 | 0.25 | 10,749 | 7,154 | 50 |
| 9 | 0.10 | 9,012 | 6,810 | 32 |
| CE-2 | 0.00 | 6,581 | - | - |

Example 10 and Comparative Examples CE-4 and CE-5

The polishing solutions of Example 10 and Comparative Examples CE-4 and CE-5 were prepared according to the compositions of Table 4a. The two acids used were iminodiacetic acid (IDA-P), a multifunctional amino acid having two acid groups, and 2-hydroxyisobutyric acid (HIBA), a monofunctional hydroxy-carboxylic acid. Each solution was used to polish a copper blanket wafer. The total number of organic acid groups in the polishing solution was held essentially constant for all the examples. Removal rate results are shown in Table 4b as a function of the mole fraction of organic acid groups in the solution from HIBA. A linear estimate of the removal rates for Example 10 was made based on the removal rates of Comparative Examples CE-4 and CE-5. The percent increase of the measured removal rate relative to the linear estimate is shown in the last column of Table 4b. The combination of acids gave a higher removal rate than either acid alone.

Table 4a: Composition of polishing solutions (amounts in grams).

| Example | CE-4 | 10 | CE-5 |
|---|---|---|---|
| DI Water | 563.0 | 581.7 | 595.4 |
| APDB | 40.2 | 40.2 | 40.2 |
| BTAS | 251 | 251 | 251 |
| IDA-P | - | 33.0 | 57.6 |
| HIBA | 90.0 | 38.3 | - |
| 30HP | 110 | 110 | 110 |

Table 4b: Removal rates.

| Example | Mole Fraction of Acid Groups from HIBA | Removal Rate (Å/min) | Linear Estimate (Å/min) | % Increase |
|---|---|---|---|---|
| CE-4 | 1.00 | 8,621 | - | - |
| 10 | 0.43 | 11,212 | 6,764 | 66 |
| CE-5 | 0.00 | 5,389 | - | - |

Example 11 and Comparative Examples CE-6 and CE-7

The polishing solutions of Example 11 and Comparative Examples CE-6 and CE-7 were prepared according

to the compositions of Table 5a. These solutions were prepared to be basic with a pH = 8.34 ± 0.03 (prior to 30HP addition). Comparative Example CE-6 required 51.1 g of ammonia solution, Example 11 required 21.6 g ammonia solution, and Comparative Example CE-7 required 29.4 g ammonia solution to reach the desired pH. The two acids used were L-aspartic acid (L-AA), a multifunctional amino acid having two acid groups, and L-LA, a monofunctional hydroxy-carboxylic acid. The total number of organic acid groups in the polishing solution was held essentially constant for all the examples. The solutions were used to polish a copper blanket wafer. Removal rate results are shown in Table 5b as a function of the mole fraction of organic acid groups in the solution from L-LA. A linear estimate of the removal rate for Example 11 was made based on the removal rates of Comparative Examples CE-6 and CE-7. The percent increase of the measured removal rate relative to the linear estimate is shown in the last column of Table 5b. The combination of acids gave a higher removal rate than either acid alone.

Table 5a: Composition of polishing solutions (amounts in grams).

| Example | DI Water | APDB | BTAS | L-AA | L-LA | 30HP |
|---|---|---|---|---|---|---|
| CE-6 | 550.0 | 100.4 | 251 | - | 91.7 | 110 |
| 11 | 558.0 | 100.4 | 251 | 33.0 | 39.0 | 110 |
| CE-7 | 566.0 | 100.4 | 251 | 57.6 | - | 110 |

Table 5b: Removal rates.

| Example | Mole Fraction of Acid Groups from L-LA | Removal Rate (Å/min) | Linear Estimate (Å/min) | % Increase |
|---|---|---|---|---|
| CE-6 | 1.00 | 1,825 | - | - |
| 11 | 0.43 | 2,346 | 2,084 | 13 |
| CE-7 | 0.00 | 2,275 | - | - |

Example 12 and Comparative Example CE-8

The polishing solutions of Example 12 and Comparative Example CE-8 were prepared according to the compositions of Table 6a. The two acids used were IDA-P, a multifunctional amino acid having two acid groups, acetic acid (AcA), a monofunctional simple carboxylic acid. Each solution was used to polish a copper blanket wafer. The total number of organic acid groups in the polishing solution was held essentially constant for all the examples. Removal rate results are shown in Table 6b as a function of the mole fraction of organic acid groups in the solution from AcA. A linear estimate of the removal rate for Example 12 was made based on the removal rates of Comparative Examples CE-5 and CE-8. The percent increase of the measured removal rate relative to the linear estimate is shown in the last column of Table 6b. The combination of acids gave a higher removal rate than either acid alone.

Table 6a: Composition of polishing solutions (amounts in grams).

| Example | DI Water | APDB | BTAS | IDA-P | AcA | 30HP |
|---|---|---|---|---|---|---|
| CE-8 | 601.6 | 40.2 | 251 | - | 51.9 | 110 |
| 12 | 598.4 | 40.2 | 251 | 33.0 | 22.1 | 110 |

Table 6b: Removal rates.

| Example | Mole Fraction of Acid Groups from AcA | Removal Rate (Å/min) | Linear Estimate (Å/min) | % Increase |
|---|---|---|---|---|
| CE-8 | 1.00 | 2,960 | - | - |
| 12 | 0.43 | 8,212 | 4,355 | 89 |
| CE-5 | 0.00 | 5,389 | - | - |

Example 13 and Comparative Example CE-9

The polishing solutions of Example 13 and Comparative Example CE-9 were prepared according to the compositions of Table 7a. The two acids used were IDA-P, a multifunctional amino acid having two acid groups, and propionic acid (PrA), a monofunctional simple carboxylic acid. The total number of organic acid groups in the polishing solution was held essentially constant for all the examples. The solutions were used to polish a copper blanket wafer. Removal rate results are shown in Table 7b as a function of the mole fraction of organic acid groups in the solution from PrA. A linear estimate of the removal rate for Example 13 was made based on the removal rates of Comparative Examples CE-5 and CE-9. The percent increase of the measured removal rate relative to the linear estimate is shown in the last column of Table 7b. The combination of acids gave a higher removal rate than either acid alone.

Table 7a: Composition of polishing solutions (amounts in grams).

| Example | DI Water | APDB | BTAS | IDA-P | PrA | 30HP |
|---|---|---|---|---|---|---|
| CE-9 | 588.9 | 40.2 | 251 | - | 64.1 | 110 |
| 13 | 592.7 | 40.2 | 251 | 33.0 | 27.3 | 110 |

Table 7b: Removal rates.

| Example | Mole Fraction of Acid Groups from PrA | Removal Rate (Å/min) | Linear Estimate (Å/min) | % Increase |
|---|---|---|---|---|
| CE-9 | 1.00 | 2,141 | - | - |
| 13 | 0.43 | 8,193 | 4,007 | 104 |
| CE-5 | 0.00 | 5,389 | - | - |

Example 14 and Comparative Example CE-10

The polishing solutions of Example 14 and Comparative Example CE-10 were prepared according to the compositions of Table 8a. The two acids used were IDA-P, a multifunctional amino acid having two acid groups, and succinic acid (SA), a multifunctional simple carboxylic acid having two acid groups. Each solution was used to polish a copper blanket wafer. The total number of organic acid groups in the polishing solution was held essentially constant for all the examples. Removal rate results are shown in Table 8b as a function of the mole fraction of organic acid groups in the solution from SA. A linear estimate of the removal rate for Example 14 was made based on the removal rates of Comparative Examples CE-5 and CE-10. The percent increase of the measured removal rate relative to the linear estimate is shown in the last column of Table 8b. The combination of acids gave a higher removal rate than either acid alone.

Table 8a: Composition of polishing solutions (amounts in grams).

| Example | DI Water | APDB | BTAS | IDA-P | SA | 30HP |
|---|---|---|---|---|---|---|
| CE-10 | 602.0 | 40.2 | 251 | - | 51.0 | 110 |
| 14 | 598.3 | 40.2 | 251 | 33.0 | 21.7 | 110 |

Table 8b: Removal rates.

| Example | Mole Fraction of Acid Groups from SA | Removal Rate (Å/min) | Linear Estimate (Å/min) | % Increase |
|---|---|---|---|---|
| CE-10 | 1.00 | 2,999 | - | - |
| 14 | 0.43 | 5,858 | 4,372 | 34 |
| CE-5 | 0.00 | 5,389 | - | - |

Example 15 and Comparative Example CE-11

The polishing solutions of Example 15 and Comparative Example CE-11 were prepared according to the compositions of Table 9a. The two acids used were μIDA-P, a multifunctional amino acid having two acid groups, and glutaric acid (GA), a multifunctional simple carboxylic acid having two acid groups. The total number of organic acid groups in the polishing solution was held essentially constant for all the examples. The solutions were used to polish a copper blanket wafer. Removal rate results are shown in Table 9b as a function of the mole fraction of organic acid groups in the solution from GA. A linear estimate of the removal rate for Example 15 was made based on the removal rates of Comparative Examples CE-5 and CE-11. The percent increase of the measured removal rate relative to the linear estimate is shown in the last column of Table 9b. The combination of acids gave a higher removal rate than either acid alone.

Table 9a: Composition of polishing solutions (amounts in grams).

| Example | DI Water | APDB | BTAS | IDA-P | GA | 30HP |
|---|---|---|---|---|---|---|
| CE-11 | 595.9 | 40.2 | 251 | - | 57.1 | 110 |
| 15 | 595.7 | 40.2 | 251 | 33.0 | 24.3 | 110 |

Table 9b: Removal rates.

| Example | Mole Fraction of Acid Groups from GA | Removal Rate (Å/min) | Linear Estimate (Å/min) | % Increase |
|---|---|---|---|---|
| CE-11 | 1.00 | 2,645 | - | - |
| 15 | 0.43 | 7,151 | 4,222 | 69 |
| CE-5 | 0.00 | 5,389 | - | - |

Example 16 and Comparative Example CE-12

The polishing solutions of Example 16 and Comparative Example CE-12 were prepared according to the compositions of Table 10a. The two acids used were IDA-H, a multifunctional amino acid having two acid groups, and citric acid (CA), a multifunctional hydroxy-carboxylic acid having three acid groups. Each solution was used to polish a copper blanket wafer. The total number of organic acid groups in the polishing solution was held essentially constant for all the examples. Removal rate results are shown in Table 10b as a function of the mole fraction of organic acid groups in the solution from CA. A linear estimate of the removal rate for Example 16 was made based on the removal rates of Comparative Examples CE-2 and CE-12. The percent increase of the measured removal rate relative to the linear estimate is shown in the last column of Table 10b.

Table 10a: Composition of polishing solutions (amounts in grams).

| Example | DI Water | APDB | BTAS | IDA-H | CA | 30HP |
|---|---|---|---|---|---|---|
| CE-12 | 597.9 | 40.2 | 251 | - | 55.4 | 110 |
| 16 | 596.7 | 40.2 | 251 | 33.0 | 23.6 | 110 |

Table 10b: Removal rates.

| Example | Mole Fraction of Acid Groups from CA | Removal Rate (Å/min) | Linear Estimate (Å/min) | % Increase |
|---|---|---|---|---|
| CE-12 | 1.00 | 10,579 | - | - |
| 16 | 0.43 | 10,027 | 8,288 | 21 |
| CE-2 | 0.00 | 6,581 | - | - |

Example 17 and Comparative Examples CE-13 and CE-14

The polishing solutions of Example 17 and Comparative Examples CE-13 and CE-14 were prepared according

to the compositions of Table 11a. The two acids used were IDA-P, a multifunctional amino acid having two acid groups, and ethylenediaminetetraacetic acid (EDTA), a multifunctional amino acid having four acid groups. Due to the increase in the amount of APDB, significant amounts of phosphoric acid were required to achieve the desired pH. Comparative Example CE-13 required 47.0 g, Example 17 required 51.7 g and Comparative Example CE-14 required 54.6 g. Each solution was used to polish a copper blanket wafer. The total number of organic acid groups in the polishing solution was held essentially constant for all the examples. Removal rate results are shown in Table 11b as a function of the mole fraction of organic acid groups in the solution from EDTA. A linear estimate of the removal rate for Example 17 was made based on the removal rates of Comparative Examples CE-13 and CE-14. The percent increase of the measured removal rate relative to the linear estimate is shown in the last column of Table 11b.

Table 11a: Composition of polishing solutions (amounts in grams).

| Example | DI Water | APDB | BTAS | IDA-P | EDTA | 30HP |
|---|---|---|---|---|---|---|
| CE-13 | 519.9 | 100.4 | 251 | - | 63.2 | 110 |
| 17 | 500.6 | 100.4 | 251 | 28.8 | 31.6 | 110 |
| CE-14 | 500.6 | 100.4 | 251 | 57.6 | - | 110 |

Table 11b : Removal rates.

| Example | Mole Fraction of Acid Groups from EDTA | Removal Rate (Å/min) | Linear Estimate (Å/min) | % Increase |
|---|---|---|---|---|
| CE-13 | 1.00 | 3,993 | - | - |
| 17 | 0.50 | 5,183 | 4,836 | 7 |
| CE-14 | 0.00 | 5,679 | - | - |

Example 18 and Comparative Example CE-15

The polishing solutions of Example 18 and Comparative Example CE-15 were prepared according to the compositions of Table 12a. The two acids used were EDTA, a multifunctional amino acid having four acid groups, and L-LA, a monofunctional hydroxy-carboxylic acid. Due to the increase in the amount of APDB, significant amounts of phosphoric acid were required to achieve the desired pH. Comparative Example CE-15 required 56.1 g and Example 18 required 52.3 g. Each solution was used to polish a copper blanket wafer. The total number of organic acid groups in the polishing solution was held essentially constant for all the examples. Removal rate results are shown in Table 12b as a function of the mole fraction of organic acid groups in the solution from L-LA. A linear estimate of the removal rate for Example 18 was made based on the removal rates of Comparative Examples CE-13 and CE-15. The percent increase of the measured removal rate relative to the linear estimate is shown in the last column of Table 12b.

Table 12a: Composition of polishing solutions (amounts in grams).

| Example | DI Water | APDB | BTAS | EDTA | L-LA | 30HP |
|---|---|---|---|---|---|---|
| CE-15 | 465.0 | 100.4 | 251 | - | 91.7 | 110 |
| 18 | 485.3 | 100.4 | 251 | 36.2 | 39.0 | 110 |

Table 12b: Removal rates.

| Example | Mole Fraction of Acid Groups from L-LA | Removal Rate (Å/min) | Linear Estimate (Å/min) | % Increase |
|---|---|---|---|---|
| CE-15 | 1.00 | 7,734 | - | - |
| 18 | 0.43 | 6,541 | 5,585 | 17 |
| CE-13 | 0.00 | 3993 | - | - |

Example 19 and Comparative Example CE-16

The polishing solutions of Example 19 and Comparative Example CE-16 were prepared according to the compositions of Table 13a. The two acids used were IDA-P, a multifunctional amino acid having two acid groups, and L-alanine (L-AL), a monofunctional amino acid. Each solution was used to polish a copper blanket wafer. The total number of organic acid groups in the polishing solution was held essentially constant for all the examples. Removal rate results are shown in Table 13b as a function of the mole fraction of organic acid groups in the solution from L-AL. A linear estimate of the removal rate for Example 19 was made based on the removal rates of Comparative Examples CE-5 and CE-16. The percent increase of the measured removal rate relative to the linear estimate is shown in the last column of Table 13b. The combination of acids gave a higher removal rate than either acid alone.

Table 13a: Composition of polishing solutions (amounts in grams).

| Example | DI Water | APDB | BTAS | IDA-P | L-AL | 30HP |
|---|---|---|---|---|---|---|
| CE-16 | 575.9 | 40.2 | 251 | - | 77.1 | 110 |
| 19 | 596.7 | 40.2 | 251 | 33.0 | 32.8 | 110 |

Table 13b: Removal rates.

| Example | Mole Fraction of Acid Groups from L-AL | Removal Rate (Å/min) | Linear Estimate (Å/min) | % Increase |
|---|---|---|---|---|
| CE-16 | 1.00 | 5,322 | - | - |
| 19 | 0.43 | 5,636 | 5.360 | 5 |
| CE-5 | 0.00 | 5,389 | - | - |

Example 20

The polishing solution of Example 20 contained: 581.2g DI water, 40.2g APDB, 251g BTAS, 45.8g L-LA, 26.0g AcA, and 110g 30HP. L-LA is a monofunctional hydroxy-carboxylic acid, and AcA is a monofunctional simple carboxylic acid. The solution was used to polish a copper blanket wafer. Removal rate results are shown in Table 14 as a function of the mole fraction of organic acid groups in the solution from L-LA. A linear estimate of the removal rate for Example 20 was made based on the removal rates of Comparative Examples CE-3 and CE-8. The percent increase of the measured removal rate relative to the linear estimate is shown in the last column of Table 14.

Table 14: Removal rates.

| Example | Mole Fraction of Acid Groups from L-LA | Removal Rate (Å/min) | Linear Estimate (Å/min) | % Increase |
|---|---|---|---|---|
| CE-3 | 1.00 | 8,874 | - | - |
| 20 | 0.50 | 6,923 | 5,917 | 17 |
| CE-8 | 0.00 | 2,960 | - | - |

Example 21

The polishing solution of Example 21 contained: 581.7g DI water, 40.2g APDB, 251g BTAS, 45.8g L-LA, 25.5 SA, and 110g 30HP. L-LA is a monofunctional hydroxy-carboxylic acid, and SA is a multifunctional simple carboxylic acid having two acid groups. The solution was used to polish a copper blanket wafer. Removal rate results are shown in Table 15 as a function of the mole fraction of organic acid groups in the solution from L-LA. A linear estimate of the removal rate for Example 21 was made based on the removal rates of Comparative Examples CE-3 and CE-10. The percent increase of the measured removal rate relative to the linear estimate is shown in the last column of Table 15.

Table 15: Removal rates.

| Example | Mole Fraction of Acid Groups from L-LA | Removal Rate (Å/min) | Linear Estimate (Å/min) | % Increase |
|---|---|---|---|---|
| CE-3 | 1.00 | 8,874 | - | - |
| 21 | 0.50 | 6,314 | 5,937 | 6 |
| CE-10 | 0.00 | 2,999 | - | - |

Comparative Examples CE-17 and CE-18

The polishing solutions of Comparative Examples CE-17 and CE-18 were prepared according to the compositions of Table 16a. The two acids used were IDA-P, a multifunctional amino acid having two acid groups, and L-malic acid (L-MA), a multifunctional hydroxy-carboxylic acid having two acid groups. Each solution was used to polish a copper blanket wafer. The total number of organic acid groups in the polishing solution was held essentially constant for all the examples. Removal rate results are shown in Table 16b as a function of the mole fraction of organic acid groups in the solution from L-MA. A linear estimate of the removal rate for Comparative Example CE-18 was made based on the removal rates of Comparative Examples CE-5 and CE-17. The percent increase relative to the linear estimate is shown in the last column of Table 16b.

Table 16a: Composition of polishing solutions (amounts in grams).

| Example | DI Water | APDB | BTAS | IDA-P | L-MA | 30HP |
|---|---|---|---|---|---|---|
| CE-17 | 595.0 | 40.2 | 251 | - | 58.0 | 110 |
| CE-18 | 595.3 | 40.2 | 251 | 33.0 | 24.7 | 110 |

Table 16b: Removal rates.

| Example | Mole Fraction of Acid Groups from L-MA | Removal Rate (Å/min) | Linear Estimate (Å/min) | % Increase |
|---|---|---|---|---|
| CE-17 | 1.00 | 7,914 | - | - |
| CE-18 | 0.43 | 5,328 | 6,463 | -18 |
| CE-5 | 0.00 | 5,389 | - | - |

Comparative Example CE-19

The polishing solution of Comparative Example CE-19 contained: 550.0g DI water, 40.2g APDB, 251g BTAS, 44.2g L-AL, 39.0g L-LA, and 110g 30HP. L-AL is a monofunctional amino acid, and L-LA is monofunctional hydroxy-carboxylic acid. The solution was used to polish a copper blanket wafer. Removal rate results are shown in Table 17 as a function of the mole fraction of organic acid groups in the solution from L-LA. A linear estimate of the removal rate for Comparative Example CE-19 was made based on the removal rates of Comparative Examples CE-3 and CE-16. The percent increase of the measured removal rate relative to the linear estimate is shown in the last column of Table 17.

Table 17: Removal rates.

| Example | Mole Fraction of Acid Groups from L-LA | Removal Rate (Å/min) | Linear Estimate (Å/min) | % Increase |
|---|---|---|---|---|
| CE-3 | 1.00 | 8,874 | - | - |
| CE-19 | 0.43 | 6,326 | 5,585 | -7 |
| CE-16 | 0.00 | 5,322 | - | - |

Example 22

The polishing solution of Example 22 contained a ternary organic acid mixture prepared from IDA-P, a multifunctional amino acid having two acid groups; HIBA, a monofunctional hydroxy-carboxylic acid; and AcA, a monofunctional simple carboxylic acid. The specific composition was: 589.7g DI water, 40.2g APDB, 251g BTAS, 33.0g IDA-P, 19.2g HIBA, 11.1g AcA and 110g 30HP. The polishing solution was used to polish a copper blanket wafer. The removal rate was measured to be 10,357 Å/min. A linear estimate of the removal rate for Example 22 was made based on the removal rates of Comparative Examples CE-4, CE-5, and CE-8. The calculated value was 5,560 Å/min. The measured value represented an 86% increase over the linear estimate based on Equation 1. The combination of acids gave a higher removal rate than any one of the acids alone.

## Claims

**1.** A polishing solution comprising an oxidizing agent, a first organic acid and a second organic acid; wherein:

the first organic acid is a multifunctional amino acid; and
the second organic acid selected from the group consisting of simple carboxylic acids, monofunctional hydroxy-carboxylic acids, and combinations thereof;

wherein the simple carboxylic acid consists of carbon, hydrogen, and one or more carboxyl groups.

**2.** The polishing solution according to claim 1, wherein the polishing solution is either an acidic solution having a pH of at least 2 and no greater than 6; or a neutral solution having a pH of between 6 and 8.

**3.** The polishing solution of claim 1 or 2, wherein the multifunctional amino acid is selected from the group consisting of iminodiacetic acids and combinations of iminodiacetic acids.

**4.** The polishing solution of claim 1 or 2, wherein the second organic acid is a monofunctional simple carboxylic acid.

**5.** The polishing solution of claim 4, wherein the monofunctional simple carboxylic acid is selected from the group consisting of formic acid, acetic acid, propionic acid, butyric acid, isobutyric acid, 3-butenoic acid, and combinations thereof.

**6.** The polishing solution of claim 1 or 2, wherein the second organic acid is a multifunctional simple carboxylic acid.

**7.** The polishing solution of claim 6, wherein the multifunctional simple carboxylic acid is a difunctional simple carboxylic acid selected from the group consisting of oxalic acid, malonic acid, methylmalonic acid, succinic acid, glutaric acid, adipic acid, maleic acid, fumaric acid, and combinations thereof.

**8.** The polishing solution of claim 1 or 2, wherein the second organic acid is a monofunctional hydroxy-carboxylic acid.

**9.** The polishing solution of claim 8, wherein the monofunctional hydroxy-carboxylic acid selected from the group consisting of glyceric acid, glycolic acid, lactic acid, hydroxyl butanoic acid, 3-hydroxy propionic acid, methyllactic acid, and combinations thereof.

**10.** The polishing solution of any one of claims 1-9, further comprising a third organic acid selected from the group consisting of simple carboxylic acids, monofunctional hydroxy-carboxylic acids, and combinations thereof,

**11.** The polishing solution of any one of claims 1-10, further comprising abrasive particles,

**12.** A polishing solution comprising an oxidizing agent, two different organic acids, a first organic acid and a second organic acid wherein

(a) the first organic acid is a first multifunctional amino acid and the second organic acid is selected from the group consisting of:

(i) a second multifunctional amino acid;

(ii) a monofunctional simple carboxylic acid,
(iii) a multifunctional simple carboxylic acid;
(iv) a monofunctional hydroxy-carboxylic acid;
(vi) combinations thereof; or

(b) the first organic acid is a monofunctional hydroxy-carboxylic acid and the second organic acid is selected from the group consisting of:

(i) a monofunctional simple carboxylic acid;
(ii) a multifunctional simple carboxylic acid; and
(iii) combinations thereof;

wherein, as tested according to the Rate Removal Test Procedure, the removal rate obtained using the polishing solution is greater than the removal rate predicted by a linear estimate based on the removal rate obtained using a polishing solution containing the first organic acid alone and the removal rate obtained using a polishing solution containing the second organic acid alone; and
wherein each monofunctional simple carboxylic acid consists of carbon, hydrogen, and one carboxyl group, and each multifunctional simple carboxylic acid consists of carbon, hydrogen, and a plurality of carboxyl groups.

**13.** The polishing solution of claim 12, wherein, as tested according to the Rate Removal Test Procedure, the removal rate obtained using the polishing solution is greater than both the removal rate obtained using a polishing solution containing the first organic acid alone and the removal rate obtained using a polishing solution containing the second organic acid alone,

**14.** A method of polishing a surface of a substrate comprising:

(a) introducing the polishing solution of any one of claims 1-13 to an interface between the surface of the substrate and a surface of a polishing article, optionally wherein the polishing solution comprises at least one of abrasive particles, a passivating agent, a buffer, and an oxidizing agent, and optionally wherein the polishing article is a fixed abrasive article; and
(b) providing a relative motion between the surface of the substrate and the surface of the polishing article.

**15.** The method of claim 14, wherein the surface of the substrate comprises a metal, optionally wherein the metal is copper.

## Patentansprüche

**1.** Polierlösung, umfassend ein Oxidationsmittel, eine erste organische Säure und eine zweite organische Säure, wobei die erste organische Säure eine multifunktionelle Aminosäure ist und
die zweite organische Säure aus der Gruppe bestehend aus einfachen Carbonsäuren, monofunktionellen Hydroxycarbonsäuren und Kombinationen davon ausgewählt ist;
wobei die einfache Carbonsäure aus Kohlenstoff, Wasserstoff und einer oder mehreren Carboxylgruppen besteht.

**2.** Polierlösung nach Anspruch 1, bei der es sich entweder um eine saure Lösung mit einem pH-Wert von mindestens 2 und höchstens 6 oder eine neutrale Lösung mit einem pH-Wert zwischen 6 und 8 handelt.

**3.** Polierlösung nach Anspruch 1 oder 2, wobei die multifunktionelle Aminosäure aus der Gruppe bestehend aus Iminodiessigsäuren und Kombinationen von Iminodiessigsäuren ausgewählt ist.

**4.** Polierlösung nach Anspruch 1 oder 2, wobei die zweite organische Säure eine monofunktionelle einfache Carbonsäure ist.

**5.** Polierlösung nach Anspruch 4, wobei die monofunktionelle einfache Carbonsäure aus der Gruppe bestehend aus Ameisensäure, Essigsäure, Propionsäure, Buttersäure, Isobuttersäure, 3-Butensäure und Kombinationen davon ausgewählt ist.

**6.** Polierlösung nach Anspruch 1 oder 2, wobei die zweite organische Säure eine multifunktionelle einfache Carbonsäure ist.

**7.** Polierlösung nach Anspruch 6, wobei die multifunktionelle einfache Carbonsäure eine aus der Gruppe bestehend aus Oxalsäure, Malonsäure, Methylmalonsäure, Bernsteinsäure, Glutarsäure, Adipinsäure, Maleinsäure, Fumarsäure und Kombinationen davon ausgewählte difunktionelle einfache Carbonsäure ist.

**8.** Polierlösung nach Anspruch 1 oder 2, wobei die zweite organische Säure eine monofunktionelle Hydroxycarbonsäure ist.

**9.** Polierlösung nach Anspruch 8, wobei die monofunktionelle Hydroxycarbonsäure aus der Gruppe bestehend aus Glycerinsäure, Glykolsäure, Milchsäure, Hydroxybutansäure, 3-Hydroxypropionsäure, Methylmilchsäure und Kombinationen davon ausgewählt ist.

**10.** Polierlösung nach einem der Ansprüche 1-9, ferner umfassend eine dritte organische Säure, die aus der Gruppe bestehend aus einfachen Carbonsäuren, monofunktionellen Hydroxycarbonsäuren und Kombinationen davon ausgewählt ist.

**11.** Polierlösung nach einem der Ansprüche 1-10, ferner umfassend Schleifteilchen.

**12.** Polierlösung, umfassend ein Oxidationsmittel, zwei verschiedene organische Säuren, eine erste organische und eine zweite organische Säure, wobei

(a) die erste organische Säure eine erste multifunktionelle Aminosäure ist und die zweite organische Säure aus der Gruppe bestehend aus:

(i) einer zweiten multifunktionellen Aminosäure;
(ii) einer monofunktionellen einfachen Carbonsäure;
(iii) einer multifunktionellen einfachen Carbonsäure;
(iv) einer monofunktionellen Hydroxycarbonsäure und
(v) Kombinationen davon

ausgewählt ist; oder
(b) die erste organische Säure eine monofunktionelle Hydroxycarbonsäure ist und die zweite organische Säure aus der Gruppe bestehend aus:

(i) einer monofunktionellen einfachen Carbonsäure;
(i) einer multifunktionellen einfachen Carbonsäure und
(iii) Kombinationen davon

ausgewählt ist;

wobei die unter Verwendung der Polierlösung erhaltene Abtragungsrate beim Test gemäß der Rate Removal Test Procedure größer ist als die durch eine lineare Abschätzung erhaltenen Abtragungsrate unter Verwendung einer Polierlösung, die nur die erste organische Säure enthält, erhaltenen und der unter Verwendung einer Polierlösung, die nur die zweite organische Säure enthält, Abtragungsrate vorhergesagte Abtragungsrate und
wobei jede monofunktionelle einfache Carbonsäure aus Kohlenstoff, Wasserstoff und einer Carboxylgruppe besteht und jede multifunktionelle einfache Carbonsäure aus Kohlenstoff, Wasserstoff und mehreren Carboxylgruppen besteht.

**13.** Polierlösung nach Anspruch 12, wobei die unter Verwendung der Polierlösung erhaltene Abtragungsrate beim Test gemäß der Rate Removal Test Procedure größer ist als sowohl die unter Verwendung einer Polierlösung, die nur die erste organische Säure enthält, erhaltene Abtragungsrate als auch die unter Verwendung einer Polierlösung, die nur die zweite organische Säure enthält, erhaltene Abtragungsrate.

**14.** Verfahren zum Polieren einer Oberfläche eines Substrats, bei dem man:

(a) die Polierlösung nach einem der Ansprüche 1-13 einer Grenzfläche zwischen der Oberfläche des Substrats und einer Oberfläche eines Polierartikels zuführt, wobei die Polierlösung gegebenenfalls Schleifteilchen, ein

Passivierungsmittel, einen Puffer und/oder ein Oxidationsmittel umfaßt und es sich bei dem Polierartikel gegebenenfalls um einen Schleifartikel mit fixiertem Schleifmittel handelt; und

(b) eine relative Bewegung zwischen der Oberfläche des Substrats und der Oberfläche des Polierartikels bereitstellt.

**15.** Verfahren nach Anspruch 14, bei dem die Oberfläche des Substrats ein Metall umfaßt, bei dem es sich gegebenenfalls um Kupfer handelt.

## Revendications

**1.** Solution de polissage comprenant un oxydant, un premier acide organique et un deuxième acide organique, dans laquelle :

le premier acide organique est un acide aminé multifonctionnel ; et
le deuxième acide organique est choisi dans le groupe constitué par les acides carboxyliques simples, les acides hydroxycarboxyliques monofonctionnels, et les combinaisons de ceux-ci ;

dans lequel les acides carboxyliques simples se composent de carbone, d'hydrogène et d'un ou plusieurs groupes carboxyle.

**2.** Solution de polissage selon la revendication 1, la solution de polissage étant une solution acide ayant un pH d'au moins 2 et ne dépassant pas 6, ou une solution neutre ayant un pH compris entre 6 et 8.

**3.** Solution de polissage selon la revendication 1 ou 2, dans laquelle l'acide aminé multifonctionnel est choisi dans le groupe constitué par les acides iminodiacétiques et les combinaisons d'acides iminodiacétiques.

**4.** Solution de polissage selon la revendication 1 ou 2, dans laquelle le deuxième acide organique est un acide carboxylique simple monofonctionnel.

**5.** Solution de polissage selon la revendication 4, dans laquelle l'acide carboxylique simple monofonctionnel est choisi dans le groupe constitué par l'acide formique, l'acide acétique, l'acide propionique, l'acide butyrique, l'acide isobutyrique, l'acide 3-buténoïque, et les combinaisons de ceux-ci.

**6.** Solution de polissage selon la revendication 1 ou 2, dans laquelle le deuxième acide organique est un acide carboxylique simple multifonctionnel.

**7.** Solution de polissage selon la revendication 6, dans laquelle l'acide carboxylique simple multifonctionnel est un acide carboxylique simple difonctionnel choisi dans le groupe constitué par l'acide oxalique, l'acide malonique, l'acide méthylmalonique, l'acide succinique, l'acide glutarique, l'acide adipique, l'acide maléique, l'acide fumarique, et les combinaisons de ceux-ci.

**8.** Solution de polissage selon la revendication 1 ou 2, dans laquelle le deuxième acide organique est un acide hydroxycarboxylique monofonctionnel.

**9.** Solution de polissage selon la revendication 8, dans laquelle l'acide hydroxycarboxylique monofonctionnel est choisi dans le groupe constitué par l'acide glycérique, l'acide glycolique, l'acide lactique, l'acide hydroxybutanoïque, l'acide 3-hydroxypropionique, l'acide méthyllactique, et les combinaisons de ceux-ci.

**10.** Solution de polissage selon l'une quelconque des revendications 1 à 9, comprenant en outre un troisième acide organique choisi dans le groupe constitué par les acides carboxyliques simples, les acides hydroxycarboxyliques monofonctionnels, et les combinaisons de ceux-ci.

**11.** Solution de polissage selon l'une quelconque des revendications 1 à 10, comprenant en outre des particules abrasives.

**12.** Solution de polissage comprenant un oxydant, deux acides organiques différents, un premier acide organique et un deuxième acide organique, dans laquelle :

(a) le premier acide organique est un premier acide aminé multifonctionnel et le deuxième acide organique est choisi dans le groupe constitué par :

(i) un deuxième acide aminé multifonctionnel ;
(ii) un acide carboxylique simple monofonctionnel ;
(iii) un acide carboxylique simple multifonctionnel ;
(iv) un acide hydroxycarboxylique monofonctionnel ; et
(v) les combinaisons de ceux-ci ; ou

(b) le premier acide organique est un acide hydroxycarboxylique monofonctionnel et le deuxième acide organique est choisi dans le groupe constitué par :

(i) un acide carboxylique simple monofonctionnel ;
(ii) un acide carboxylique simple multifonctionnel ; et
(iii) les combinaisons de ceux-ci ;

dans laquelle, comme testé selon la procédure d'essai d'enlèvement de matière, la vitesse d'enlèvement de matière obtenue en utilisant la solution de polissage est supérieure à la vitesse d'enlèvement de matière prédite par une estimation linéaire basée sur la vitesse d'enlèvement de matière obtenue en utilisant une solution de polissage contenant le premier acide organique seul et la vitesse d'enlèvement de matière obtenue en utilisant une solution de polissage contenant le deuxième acide organique seul ; et
dans laquelle chaque acide carboxylique simple monofonctionnel se compose de carbone, d'hydrogène et d'un groupe carboxyle, et chaque acide carboxylique simple multifonctionnel se compose de carbone, d'hydrogène et d'une pluralité de groupes carboxyle.

**13.** Solution de polissage selon la revendication 12, dans laquelle, comme testé selon la procédure d'essai d'enlèvement de matière, la vitesse d'enlèvement de matière obtenue en utilisant la solution de polissage est supérieure à la fois à la vitesse d'enlèvement de matière obtenue en utilisant une solution de polissage contenant le premier acide organique seul et à la vitesse d'enlèvement de matière obtenue en utilisant une solution de polissage contenant le deuxième acide organique seul.

**14.** Procédé de polissage d'une surface d'un substrat comprenant :

(a) l'introduction de la solution de polissage selon l'une quelconque des revendications 1 à 13 à une interface entre la surface du substrat et une surface d'un article de polissage, la solution de polissage comprenant éventuellement des particules abrasives et/ou un agent passivant et/ou un tampon et/ou un oxydant, et l'article de polissage étant éventuellement un article abrasif fixe ; et
(b) l'obtention d'un mouvement relatif entre la surface du substrat et la surface de l'article de polissage.

**15.** Procédé selon la revendication 14, dans lequel la surface du substrat comprend un métal, le métal étant éventuellement du cuivre.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6238592 B
- US 5014468 A
- US 5453312 A
- US 5454844 A
- US 5692950 A
- US 5820450 A
- US 5958794 A
- US 6612916 A
- WO 9849723 A

### Non-patent literature cited in the description

- **Leidheiser.** *The Corrosion of Copper, Tin, and Their Alloys,* 1971, 119-123